# EUROPEAN PATENT APPLICATION

(11) **EP 3 130 881 A1**
(43) Date of publication of application: **15.02.2017**
(21) Application number: 16183608.5
(22) Date of filing: 10.08.2016
(51) Int. Cl.: F42B 3/12

(54) **INTEGRATED BARREL/BRIDGE SUBASSEMBLY FOR AN EXPLODING FOIL INITIATOR (EFI)**

(30) Priority: 10.08.2015 US 201514822203
(71) Applicant: Excelitas Technologies Corp., Waltham, MA 02451 (US)
(72) Inventor: FISHER, Steven, Dayton, OH Ohio 45459 (US); WARREN, Donald, Bellbrook, OH Ohio 45305 (US); SPARKMAN, John, Dayton, OH Ohio 45419 (US)
(74) Representative: Eve, Rosemary Margaret

(57) **Abstract**

An integrated barrel/bridge detonator subassembly includes a polyimide flyer layer (230), a conducting layer, and a barrel layer (210). The conducting layer has an electrically conducting material laminated to a first side of the flyer layer. The conducting layer consists of a single layer of an electrically conducting material. The electrically conducting material forms a first land (232) having a first connecting pad, a second land (234) having a second connecting pad disposed opposite the first land, and a bridge (236) disposed between and providing electrical conductivity between the first land and the second land. The barrel layer (210) is formed of an insulative material and laminated to a second side of the flyer layer (230) substantially opposite the first side. The barrel layer has an opening disposed substantially opposite the bridge.

## Description

### FIELD OF THE INVENTION

The present invention relates to detonators, and more particularly, is related to Exploding Foil Initiators (EFI).

### BACKGROUND OF THE INVENTION

Detonators are used to detonate a primary charge such as an explosive of an air to surface missile. Such detonators are also used to detonate explosives used in other tactical devices, construction explosives, rocket boosters, and the like. These types of detonators must be physically robust and of high integrity. For example, an air to surface missile may be designed to pierce a bunker or other building and only then detonate the primary explosive. The detonator must, therefore, survive the shock of the launch and the impact with the bunker.

Exploding foil initiator detonators, (i.e. "chip slappers"), generally include a ceramic chip upon which is deposited two opposing conductive copper lands which taper to a narrow "bridge" portion therebetween. An electrical current is provided to the lands at the time of initiation and the bridge portion bursts sending a flying plate thereon into an explosive charge which, in turn, detonates the primary charge.

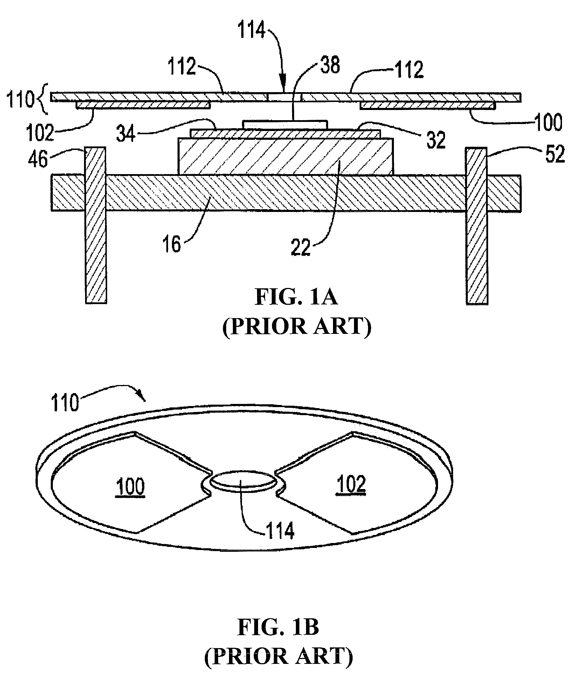

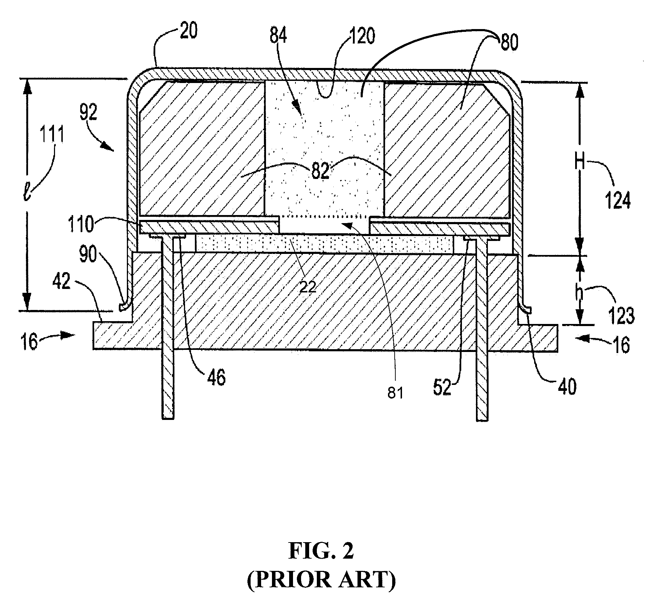

It is convenient to package a chip and the explosive charge within a standard electronics housing such as a "TO" type transistor package including a base with one or more electrical leads and a can which covers the base. FIGS. 1A, 1B, and 2 show a prior art chip slapper. Electrical connections are provided by a conductive surface rather than wires, for example robust conductive plates 100, 102 connecting to lead posts 46, 52 and conductive lands 32, 34 respectively. Conductive plates 100, 102 may be made, for example of copper or some other conductive material. Conductive copper plates 100, 102 are part of a laminated connecting barrel 110, which includes a top insulating layer 112 and a bottom conductive layer configured into conductive plates 100, 102. For example, the barrel 110 may be in the form of a laminate including an insulating layer made of polyimide such as the Kapton® product available from DuPont, Inc., and a conductive copper layer. An insulating layer 112 shields lands 32 and 34, from electrical contact with an explosive charge 80 including an optional metal sleeve 82 housing an explosive component 84. The copper layer is preferably etched away in certain areas forming conductive plates 100, 102. Then, an opening 114 is formed to be placed over a bridge portion and a flying plate 38 of the chip slapper 22 so that nothing interferes with travel of the flying plate 38 to the explosive charge 80.

The thickness of the barrel 110 may be selected to optimize the spacing between the chip slapper and the explosive component 84 of the explosive charge 80. Thus, the barrel 110 acts not only as the electrical connection between the contact posts 46, 52 of the detonator base 16 and the lands 32, 34 of the chip slapper 22, but also simultaneously acts as a spacer between the chip slapper 22 and the explosive charge 80 to ensure that the flying plate 38 travels a sufficient distance before striking the explosive component 84.

In order to ensure that the explosive charge 80 is in intimate contact with interior top surface 120 of a cap or can 20 in light of the loose tolerances and thus varying lengths 1, 111 of an enclosure wall 92 of the can 20 and varying heights h, 123 of the header wall 92 of the base 16 (common in the manufacturing of standard, low cost transistor bases and cans), the length 111 of the can 20 is selected such that the thickness of the chip slipper 22 and the thickness of the explosive charge 80 when combined with the thickness of the barrel 110, has a height H, 124 sufficient to ensure that a rim 90 of the cap 20 does not engage a flange 42 of the base 16.

Assembly of the detonator 16 is typically accomplished by first fabricating the barrel 110. A copper layer of polyimide copper laminate is etched from the polyimide layer 112 to form the conductive plates 100 and 102. The opening 114 is then punched through the polyimide layer of the barrel 110. The chip 22, FIG. 1A is then placed on the support surface of a standard TO base and secured thereto with an epoxy, adhesive, etc. The barrel 110 is then placed over the chip 22 such that the broad distal ends of each conductive plate 100, 102 contacts all of the adjacent lead posts 46, 52 of the base 16 and the tapered proximal ends contact the lands 32, 34 of the chip 22. Solder, anisotropically conductive adhesives, conductive epoxies, and other similar conventional technologies can be used to provide the connection between the conductive plates 100, 102 and both the lands 32, 34 of the chip 22 and the lead posts 46, 52 of the transistor base 16. The explosive charge assembly 80 is then placed directly on top of the barrel 110, and the cap or can 20 is placed over all of these interior components, thus enclosing them. A rim 90 of the cap 20 is then welded (e.g. using a YAG laser) at the appropriate location along the height of the header wall 40 by laser welding such that inside the top surface 120 of the can 20 is in intimate contact with the explosive material 84 of the explosive charge 80. It is desirable that the explosive charge 80 contact the inside top surface of the transistor package (can) 120 to prevent energy losses.

However, the laminated design layering cured and metalized layers has drawbacks, including, for example, diffusion between the metal contacts and the lands, and limited cure temperatures of the polyimide material that can be reached without damaging the metallization layer. Therefore, there is a need in the art to overcome one or more of the abovementioned shortcomings.

### SUMMARY OF THE INVENTION

Embodiments of the present invention provide an integrated barrel/bridge subassembly for a detonator. Briefly described, the present invention is directed to an integrated barrel/bridge detonator subassembly including a polyimide flyer layer, a conducting layer, and a barrel layer. The conducting layer has an electrically conducting material laminated to a first side of the flyer layer. The conducting layer consists of a single layer of an electrically conducting material. The electrically conducting material forms a first land having a first connecting pad, a second land having a second connecting pad disposed opposite the first land, and a bridge disposed between and providing electrical conductivity between the first land and the second land. A barrel layer formed of an insulative material is laminated to a second side of the flyer layer substantially opposite the first side. The barrel layer has an opening disposed substantially opposite the bridge.

In particular, embodiments of the present invention provide an integrated barrel/bridge detonator subassembly comprising a polyimide flyer layer; a single conducting layer of an electrically conducting material laminated directly to a first side of the flyer layer further comprising: a first land comprising a first connecting pad; a second land comprising a second connecting pad disposed opposite the first land; and a bridge disposed between and providing electrical conductivity between the first land and the second land; and a barrel layer formed of an insulating material laminated to a second side of the flyer layer substantially opposite the first side, wherein the conducting layer consists of a single layer of an electrically conducting material, and the barrel layer comprises an opening disposed substantially opposite the bridge.

Preferably the subassembly further comprises a barrier layer disposed adjacent to and overlaying the metalized lands/bridge layer, wherein the barrier layer further comprises at least one aperture exposing at least a portion of the first land and the second land.

Preferably the subassembly is shaped as a substantially circular disk.

Preferably a profile of the first land and a profile of the second land are each smaller than a profile of the flyer layer.

Preferably the at least one aperture of the barrier layer is conformed to admit an electrical lead passing through the barrier layer.

Preferably the single conducting layer is flat.

Preferably the polyimide flyer layer and the barrel layer are flat.

Preferably no portion of the single conducting layer extends beyond a plane defined by the first side of the flyer layer.

Preferably, the subassembly further comprises a barrier layer disposed adjacent to and overlaying the metalized lands/bridge layer, wherein no portion of the single conducting layer extends beyond a plane defined by a surface of the barrier layer, with which that the metalized lands/bridge layer is in contact.

The present invention is also directed to an exploding foil initiator, comprising a housing comprising a canister top, sides and a base, an explosive charge disposed within the housing top and sides, and the integrated barrel/bridge detonator subassembly discussed above disposed within the housing and adjacent to the explosive charge, a first electrically conducting post disposed through the housing base and electrically connecting to the first land; and a second electrically conducting post disposed through the housing base and electrically connecting to the second land.

The present invention is also directed to a method for forming an integrated barrel/bridge detonator subassembly, comprising the steps of curing a layer of polyimide material, attaching a single layer of conducting material directly to a first surface of the cured polyimide layer, forming a first land, a second land, and a bridge connecting the first land and the second land from the conducting material, forming a layer of an insulating material, punching an opening through the layer of insulating material; and attaching the layer of insulating material directly to a second surface of the cured polyimide layer, wherein the opening is disposed opposite from the bridge with a portion of the layer of polyimide material disposed therebetween.

Preferably the single layer of conducting material is flat, wherein when the single layer of conducting material has been attached to the first surface of the cured polyimide layer, and no portion of the single layer of conducting material extends beyond a plane defined by the first surface of the cured polyimide layer.

Preferably the method further comprises a step of sputtering the layer of conducting material upon the cured polyimide layer.

Preferably the method, further comprises a step of etching the first land, the second land, and the bridge connecting the first land and the second land from the conduction material on the cured polyimide layer.

Preferably the method further comprises a step of attaching a barrier layer adjacent to and overlaying the single layer of conducting material, wherein the barrier layer further comprises at least one aperture exposing at least a portion of the first land and the second land, wherein, when the barrier layer is adjacent to and overlaying the single layer of conducting material, no portion of the single layer of conducting material extends beyond a plane defined by a surface of the barrier layer, with which the single layer of conducting material is in contact.

Other systems, methods and features of the present invention will be or become apparent to one having ordinary skill in the art upon examining the following drawings and detailed description. It is intended that all such additional systems, methods, and features be included in this description, be within the scope of the present invention and protected by the accompanying claims.

### BRIEF DESCRIPTION OF THE DRAWINGS

The accompanying drawings are included to provide a further understanding of the invention, and are incorporated in and constitute a part of this specification. The components in the drawings are not necessarily to scale, emphasis instead being placed upon clearly illustrating the principles of the present invention. The drawings illustrate embodiments of the invention and, together with the description, serve to explain the principals of the invention.
FIG. 1A is a side sectional partially exploded view of a prior art connecting barrel.
FIG. 1B is a schematic three dimensional view of the bottom portion of the prior art connecting barrel shown in FIG. 1A.
FIG. 2 is a schematic side sectional view of the prior art complete detonator assembly.
FIG. 3 is a schematic diagram of a first embodiment of a barrel/bridge subassembly in exploded view.
FIG. 4 is a schematic wireframe diagram of the first embodiment of a barrel/bridge subassembly in exploded view.
FIG. 5 is a schematic diagram of a first embodiment of the barrel/bridge subassembly in exploded perspective view.
FIG. 6 is a schematic wireframe diagram of the first embodiment of the barrel/bridge subassembly.
FIG. 7 is a schematic sectional diagram of the barrel/bridge subassembly in a complete detonator assembly.
FIG. 8 is a schematic diagram of a second embodiment of a barrel/bridge subassembly in exploded perspective view.
FIG. 9 is a flowchart of an exemplary method for manufacturing a barrel/bridge subassembly.

### DETAILED DESCRIPTION

The following definition is useful for interpreting terms applied to features of the embodiments disclosed herein, and is meant only to define elements within the disclosure. No limitations on terms used within the claims are intended, or should be derived, thereby. Terms used within the appended claims should only be limited by their customary meaning within the applicable arts.

As used within this disclosure "substantially" means, very nearly, or within typical manufacturing tolerances as would be appreciated by a person having ordinary skill in the art. For example, "substantially contiguous" indicates continuity between two elements despite insignificant gaps that do not generally affect the function of the elements.

Reference will now be made in detail to embodiments of the present invention, examples of which are illustrated in the accompanying drawings. Wherever possible, the same reference numbers are used in the drawings and the description to refer to the same or like parts.

As explained previously, the prior art defines a barrel 110 as an insulator 112 having conductive metal plates 100, 102 attached with an opening 114 punched therethrough. The barrel 110 is then soldered to a chip slapper 22 via lands 32 and 34. A flying plate 38 is sandwiched between the chip slapper 22 and the barrel 110. The barrel 110 is positioned so the flying plate 38 is at least partially positioned beneath the opening 114 in the barrel 110. Electrical connectivity is provided from the lead posts 46, 52, through the conductive metal plates 100,102 to the lands 32, 34 and the bridge connecting the lands 32, 34. When a high current passes through the bridge, the expanding plasma from an explosion of the bridge metal foil drives the flying plate 38, or at least a portion thereof, across a gap 81, and its high-velocity impact on the charge 84 then delivers the energy and shock needed to initiate a detonation. However, due to the previous design, the opening 114 was generally left over large to accommodate for manufacturing tolerances to ensure the flying plate 38 was properly aligned with the opening 114 when the barrel 110 was attached to the chip slapper 22. Further, the large opening 114 left the explosive component 84 unsupported over the gap 81.

Embodiments of the current invention provide an improved EFI detonator device and a method for manufacturing the improved EFI detonator device. In particular, an improved barrel 210 eliminates the chip slapper 22, as well as the metal plates 100, 102 of the prior art.

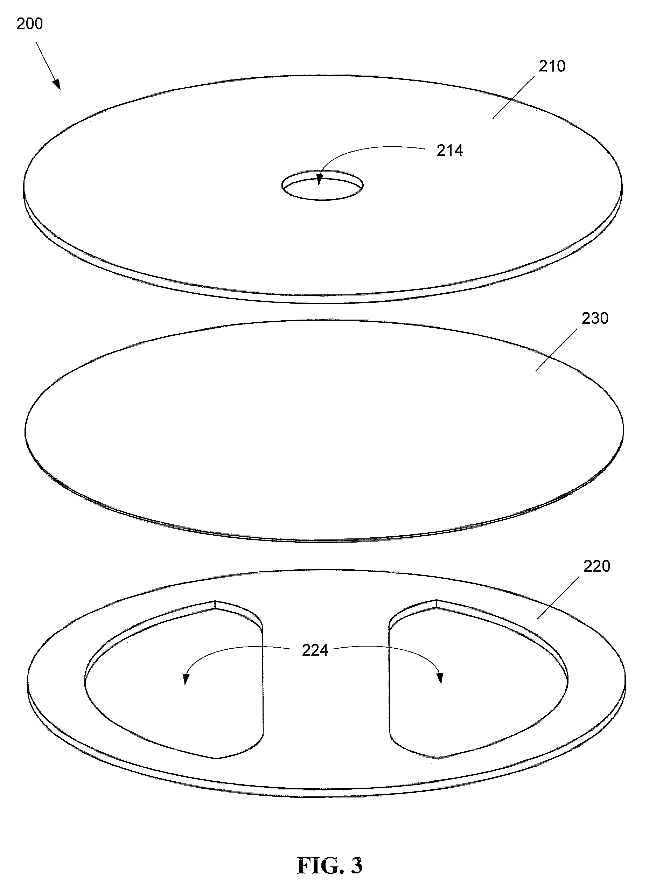

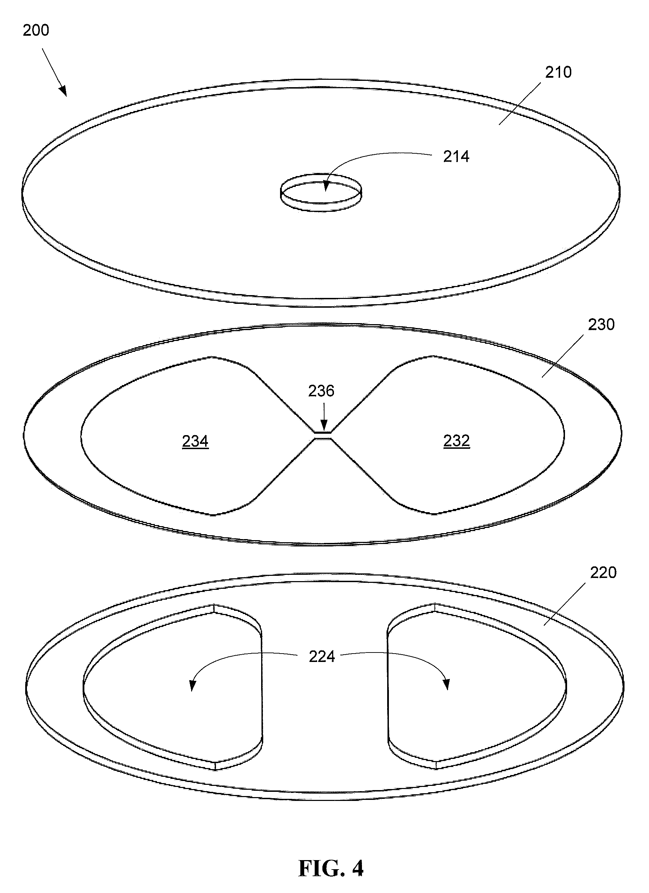

FIG. 3 shows a first embodiment of an integrated barrel/bridge subassembly 200. The subassembly 200 may be a printed and/or photo-etched flex circuit including a metalized lands/bridge layer 232, 234, 236 (FIG. 4), a flyer layer 230, a barrel layer 210, and a barrier layer 220.

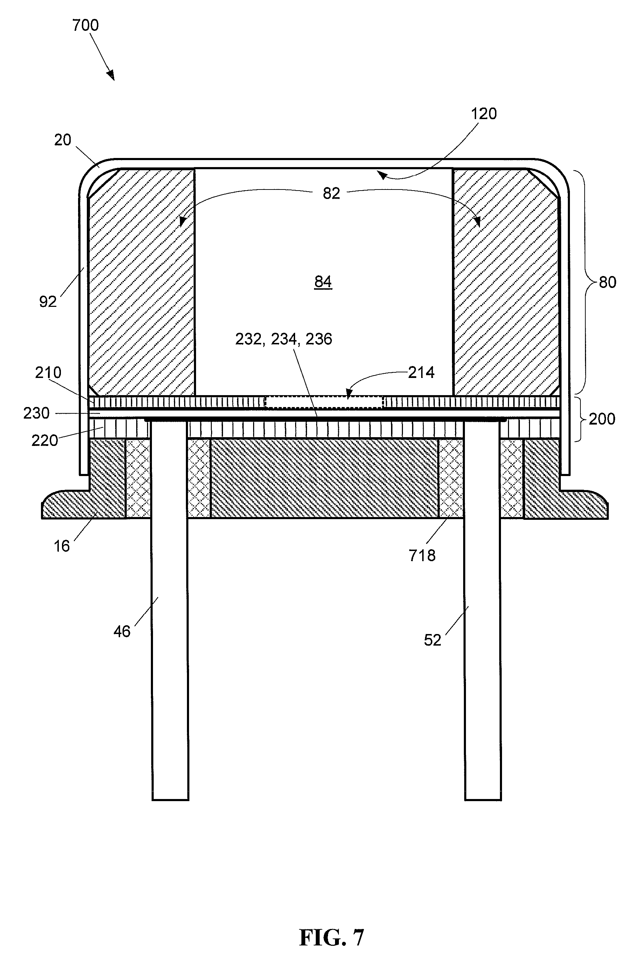

The flyer layer 230 may be formed of a polyimide material, for example but not limited to poly 4,4'-oxydiphenylene-pyromellitimide, manufactured by DuPont under the name Kapton®. Polyether ether ketone (PEEK) is another suitable material for the flyer layer 230 due to its tensile properties, high melting point, and chemical resistance. Other flexible plastic substrate materials are also possible as a flyer layer 230 material but may limit the acceptable temperature range of the detonator, depending upon the melting point of the material. The thickness of the flyer layer 230 may be determined by several factors, including the desired spacing between the flyer layer 230 and a charge 80 (FIG. 7), the type of explosive component 84 (FIG. 7) being used, and a desired magnitude of the shock to be caused by the flyer layer 230 upon striking the charge 80 (FIG. 7).

The barrel layer 210 is formed above the flyer layer 230, so that the barrel layer 210 is disposed between the flyer layer 230 and an explosive charge 80 (FIG. 7). The barrel layer 210 is generally formed of an electrically insulating material, for example, Kapton®. Other materials may include PEEK, flexible plastic substrates, and glass-reinforced epoxy laminate sheets (FR-4). The barrel layer 210 has an opening 214, for example, formed near or at the center of the barrel layer 210. The opening 214 serves as a path of least resistance between the flyer layer 230 and the explosive charge 80 (FIG. 7).

Under the first embodiment, the opening 214 is substantially circular and located substantially in the center of the barrel layer 210. In alternative embodiments, the opening 214 may be differently shaped, for example rectangular, and may be positioned off center. However, the location of the opening 210 preferably corresponds to a location of the bridge 236 (FIG. 4) of the metallization layer upon the flyer layer 230.

The thickness of the barrel layer 210 generally corresponds to the spacing distance between the flyer layer 230 and the charge 80 (FIG. 7), so the thickness of the barrel layer 210 may be determined according to the desired spacing distance between the flyer layer 230 and the charge 80 (FIG. 7). For example, the thickness of the barrel 210 may be selected to provide adequate room for expansion of plasma from explosion of the bridge 236 (FIG. 4) metal driving a portion of the flyer layer 230 through the opening 214, such that a high-velocity impact of the flyer layer 230 on the charge 80 provides the energy and shock needed to initiate a detonation.

The thickness of the flyer layer 230 may be selected to provide sufficient mass to be accelerated into the charge 80. While a thicker flyer layer 230 has more mass, a thicker flyer layer will also be propelled at a slower velocity. The barrier layer 220 provides a backstop for the exploding plasma to push against, and therefore should be sufficiently thick to resist the plasma explosion. In general, the barrier layer 220 may be thicker than the barrel layer 210 and the flyer layer 230. The flyer layer 230 is generally thicker than a conducting layer formed of the lands 232, 234 (FIG. 4) and the bridge 236 (FIG. 4). For example, the flyer layer 230 may be seven times thicker than the conductive layer 232, 234, 236 (FIG. 4).

FIG. 4 shows a wireframe view of the subassembly 200 to show the metalized lands/bridge layer 232, 234, 236 formed on the underside of the flyer layer 230. The metalized lands/bridge layer 232, 234, 236 is formed of a conductive metallic material, for example, but not limited to sputtered copper. In contrast with the prior art (FIGS. 1-2), function of the separate conductive metal plates 100,102 (FIG. 1A) and lands 32, 34 (FIG. 1A) are combined into a single conducting layer 232, 234, 236 combining a first land 232, a second land 234, connected by a bridge 236. The lands 232, 234 serve both as electrical connection points, such as solder pads, and as circuit traces, connected by a narrow bridge 236 of the conducting material. The lands 232, 234 and bridge 236 may be the same materials, such as copper. The bridge 236 may be thought of as serving the function of a fuse, such that the current passing from the first land 232 to the second land 234 is concentrated through the thin bridge 236, such that sufficient current causes the bridge 236 to explosively overheat as a plasma.

The lands 232, 234 and bridge 236 may be formed by etching a copper laminate from the polyimide flyer layer 230. For example the lands and bridge may be formed directly on the flyer layer. The polyimide material of the flyer layer 230 is preferably fully cured before forming the metalized lands/bridge layer 232, 234, 236 upon the underside of the flyer layer 230, for example, by a sputtering process. Under the first embodiment, the metalized lands/bridge layer 232, 234, 236 are further formed by etching the copper laminate from the polyimide flyer layer 230. However, under alternative embodiments the metalized lands/bridge layer 232, 234, 236 may be formed by other methods, for example, printing or sputtering the copper laminate through a mask. The metalized lands/bridge layer may be flat, as may the flyer and barrier layers.

The barrier layer 220 is positioned below the flyer layer 230 relative to the charge 80 (FIG. 7), and below and adjacent to the metallization layer 232, 234, 236. As noted above, the barrier layer 220 serves as a backstop for the shock wave that propels a portion of the flyer layer 230 through the opening 214 in the barrel layer 230 toward the charge 80 (FIG. 7).

The barrier layer 220 further serves to physically and electrically isolate the metalized layer from a housing base 16 (FIG. 7). The barrier layer 220 may have one or more apertures 224 through which electrical connections may be made with the metalized layer. Under the first embodiment, the barrier layer 220 has two apertures 224, which generally correspond in shape to the lands 232, 234. In general, the apertures 224 do not extend over the bridge 226. The barrier layer 220 may be formed of Kapton®. Other materials may include PEEK, flexible plastic substrates, and glass-reinforced epoxy laminate sheets (FR-4). In general, the barrier layer 220 may be thicker than the flyer layer 230.

The first embodiment allows the use of a fully cured flyer layer 230 material resulting in reduction of performance variation when compared to the prior art. The metallization layer 232, 234, 236 does not require dissimilar metals, for example, a first metal for the metal plates 100, 102 (FIG. 1A) and a second metal for the bridge/lands 32, 34 (FIG. 1A), thereby avoiding performance issues due to diffusion, which may occur when using dissimilar metals.

Under the first embodiment, the layers 210, 220, 230, are depicted as being substantially disk shaped, having a generally circular profile shape, corresponding to the TO housing 20. The outer profiles of the layers 210, 220, 230 may be approximately the same size, for example, three circular disks having approximately the same diameter. However, other layer profile shapes are also possible. The layer profile shapes are preferably shaped to correspond to a housing for the integrated barrel/bridge subassembly 200. In general, the flyer layer 230 is larger than the opening 214 in the barrel layer 210. A profile of the first land 232 and a profile of the second land 234 are each smaller than the profile of the flyer layer 230.

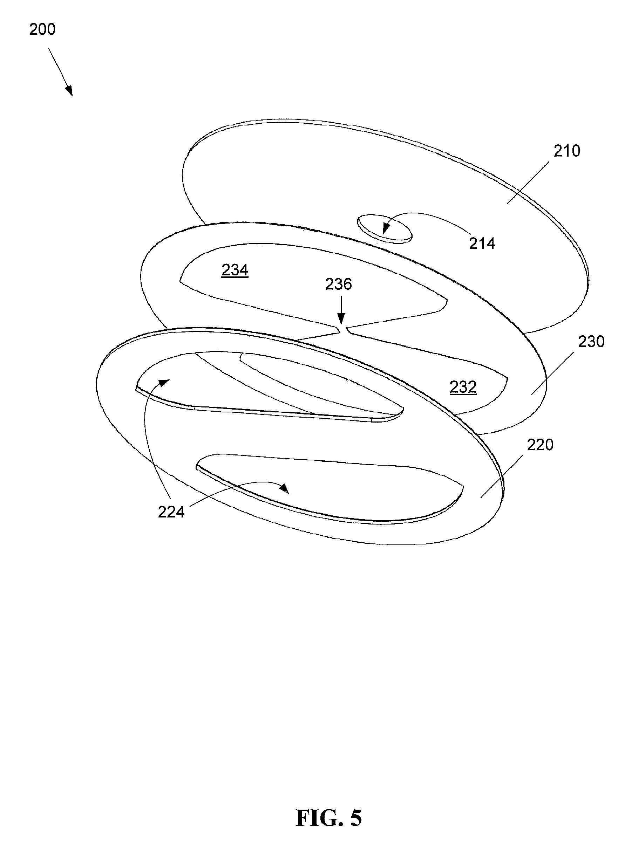

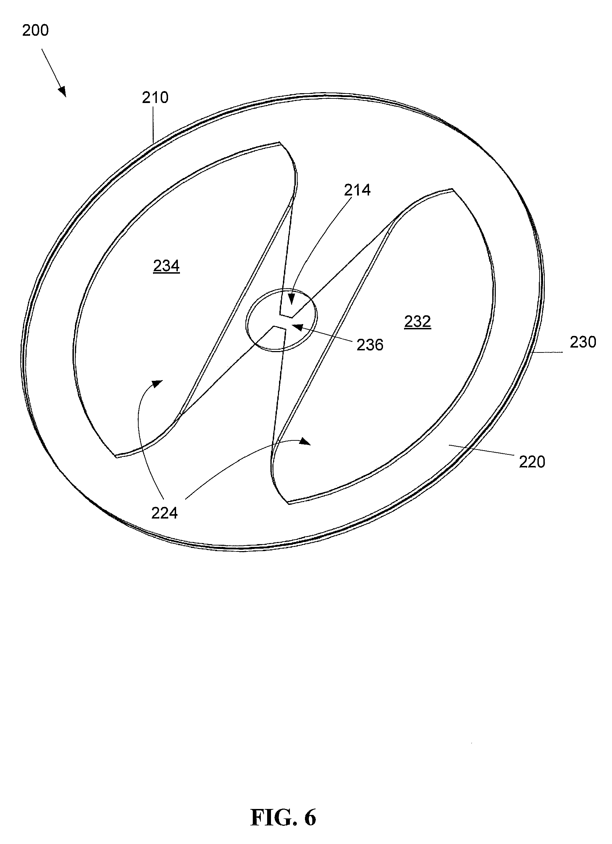

FIG. 5 shows the layers 210, 230, 220 in an exploded perspective view, while FIG. 6 shows the layers 210, 230, 220 in wireframe view as assembled. In particular, FIG.6 illustrates the juxtaposition of the bridge 236 and the opening 214.

FIG. 7 shows the barrel/bridge subassembly 200 in the context of a complete detonator assembly 700. A housing 20, for example, a TO housing can 20 or cap has an interior top surface 120. An explosive charge 80 is generally located near the interior top surface 120. Optional spacers and/or padding have been omitted for clarity. The explosive charge 80 may include an optional metal sleeve 82 housing an explosive component 84, for example, hexanitrostilbene (HNS) IV, among other explosive materials.

An enclosure wall 92 of the can 20 extends upward from a base 16. An insulator/seal 718, formed, for example, of CTE Matched Sealing Glass, for example Corning® 7052 Kovar Sealing glass, Corning® 7056 Kovar Sealing glass, Corning® 7720 Nonex Tungsten Sealing glass, or Schott® 8250 Kovar Sealing glass, may be used to seal the leads 46, 52, both electrically, and from shock waves produced by the detonator 700. In instances where hermeticity is not required, this seal may be formed with epoxy.

The integrated barrel/bridge subassembly 200 may preferably be created using flexible circuit fabrication technology. In flexible circuit fabrication, layers of the circuit may be manufactured independently or after they have been attached. These processes include punching shapes using various dies, photoetching polyimide (or insulating layer), photoetching the metal (or conductive layer) or plating metal onto various layers (for example solder plating on conductive land areas). The photoetching typically consists of applying a photosensitive material to the material layer, shining ultra violet light through a mask to cure the exposed areas, applying a developer to the photosensitive material to remove the unexposed areas leaving a chemically resistant mask, and applying a selective etchant to remove the exposed insulator or conductor. The mask is then removed to leave the patterned layer.

By layering various thicknesses of patterned and metalized Kapton®, the functionality of the barrel and bridge may be combined into one unit for consistency in the subassembly. The integrated barrel/bridge subassembly 200 operates by connecting the solder pads to pins on a round TO header which supply an appropriate electrical signal through the conductive layer 232, 234, 236. The bridge 236 ionizes and propels a portion of the Kapton® flyer layer 230 through the opening 214 in the barrel 210.

While the integrated barrel/bridge subassembly 200 may be flexible to some extent, and therefore need not be formed as a flat plane, in general the conductive layer 232, 234, 236 may be formed as a single layer that is not doubled over at any portion or otherwise contain overlapping metal portions. Further, the barrel/bridge subassembly 200 is formed as an integrated unit combining the barrier layer 210, the flyer layer 230, the conductive layer 232, 234, 236, and the barrier layer 220. Some alternative embodiments may omit the barrier layer 220.

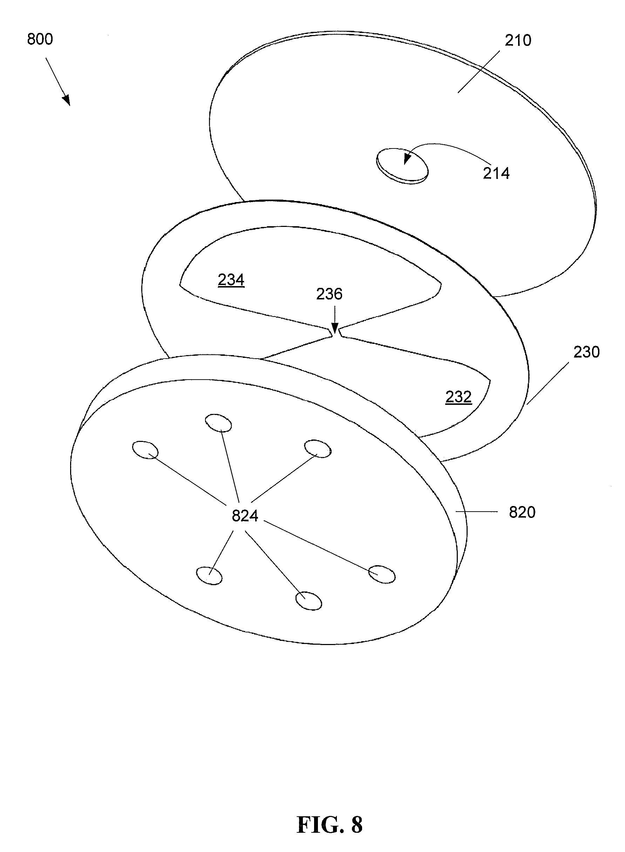

FIG. 8 is a schematic diagram of a second embodiment of a barrel/bridge subassembly 800 in exploded perspective view. The barrel layer 210 and flyer layer 230 are substantially as described in the first embodiment. Under the second embodiment, the barrier layer 820 has a plurality of apertures 824, to accommodate the lead posts 46, 52 (FIG. 7), providing close tolerance access for the lead posts 46, 52 to the lands 234, 236. While FIG. 8 shows six apertures 824, alternative embodiments may have two, three, four, five, seven or more apertures 824, corresponding to the number of lead posts 46, 52 (FIG. 7) used in the detonator 700 (FIG. 7). In general, the apertures 824 do not extend over the bridge 226. The barrier layer 820 may be thicker than the flyer layer 230, and may be formed of one or more materials providing both shock resistance and electrical insulation with respect to the flyer layer 230 and the conductive layer 232, 234, 236.

As described above, the prior art detonator generally includes a ceramic chip that is photo processed with a metal stack and flyer material placed on a supporting header, with a barrel connector soldered to connect the header contacts to the chip contact. In the present embodiments 200, 800, which may be similar to a flex-circuit, the flyer material is incorporated in the barrel connector. The chip and the connection for the chip of the prior art are eliminated by incorporating the flyer and the connection to the flyer into the barrel piece. Instead of pads as entities connecting a chip to a header, the pads are incorporated with the bridge in the barrel component. This allows for the elimination of free space of prior art detonators, resulting in improved ability to survive high shock loads.

As stated, it is contemplated that the conducting layer, comprising the first (232) and second (234) lands and the bridge (236), is flat, in addition it is contemplated that the flyer layer (230) and barrel layers (210) are flat. It is contemplated that the barrier layer is disposed adjacent to and overlaying the metalized lands/bridge layer, wherein no portion of the single conducting layer extends beyond a plane defined by a surface of the barrier layer, with which the metalized lands/bridge layer is in contact.

### Method

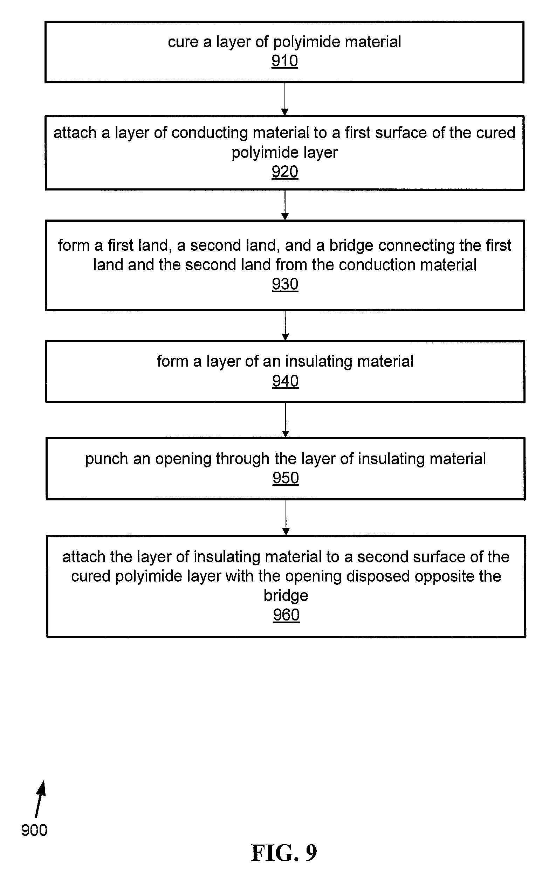

FIG. 9 is a flowchart 900 of an exemplary embodiment of a method for forming an integrated barrel/bridge detonator subassembly 200. It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention.

A layer of polyimide material 230 is cured, as shown by block 910. The layer of polyimide material serves as the flyer layer 230 of the integrated barrel/bridge detonator subassembly 200. A layer of conducting material is attached to a first surface of the cured polyimide layer 230, as shown by block 920. The conducting material may be, for example, copper or a copper composite, sputtered upon the flyer layer 230.

A first land 232, a second land 234, and a bridge 236 connecting the first land 232 and the second land 234 are formed from the conducting material, as shown by block 930. The bridge 236 may be thought of as acting as a fuse between the first land 232 and the second land 234, in that it is the weakest and hottest part of the circuit when high current is applied across the first land 232 and the second land 234.

A layer of an insulating material 210 is formed, as shown by block 940. An opening 214 is punched or otherwise formed through the layer of insulating material 210, as shown by block 950. The layer of insulating material 210 is attached to a second surface of the cured polyimide layer 230 with the opening 214 disposed opposite the bridge 236, as shown by block 960.

The exemplary method may be performed such that multiple integrated barrel/bridge detonator subassemblies 200 are formed substantially concurrently. For example, the method may incorporate solder reflow to produce hundreds of barrel/bridge detonator subassemblies 200 at once.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. An integrated barrel/bridge detonator subassembly comprising:
a polyimide flyer layer (230);
a single conducting layer of an electrically conducting material laminated directly to a first side of the flyer layer further comprising:
a first land (232) comprising a first connecting pad;
a second land (234) comprising a second connecting pad disposed opposite the first land; and
a bridge (236) disposed between and providing electrical conductivity between the first land (232) and the second land (234); and
a barrel layer (210) formed of an insulating material laminated to a second side of the flyer layer substantially opposite the first side,
wherein the conducting layer consists of a single layer of an electrically conducting material, and the barrel layer comprises an opening (214) disposed substantially opposite the bridge (236).

2. The subassembly of claim 1, further comprising a barrier layer (220) disposed adjacent to and overlaying the metalized lands/bridge layer, wherein the barrier layer further comprises at least one aperture exposing at least a portion of the first land and the second land.

3. The subassembly of claim 1, wherein the subassembly is shaped as a substantially circular disk.

4. The subassembly of claim 1, wherein a profile of the first land and a profile of the second land are each smaller than a profile of the flyer layer.

5. The subassembly of claim 2, wherein the at least one aperture of the barrier layer is conformed to admit an electrical lead passing through the barrier layer.

6. The subassembly of claim 1, wherein the single conducting layer is flat.

7. The subassembly of claim 6, wherein the polyimide flyer layer and the barrel layer are flat.

8. The subassembly of claim 6, wherein no portion of the single conducting layer extends beyond a plane defined by the first side of the flyer layer.

9. The subassembly of claim 8, further comprising a barrier layer disposed adjacent to and overlaying the metalized lands/bridge layer,
wherein no portion of the single conducting layer extends beyond a plane defined by a surface of the barrier layer, with which that the metalized lands/bridge layer is in contact.

10. An exploding foil initiator comprising:
a housing comprising a canister top, sides and a base;
an explosive charge disposed within the housing top and sides;
the integrated barrel/bridge detonator subassembly of claim 1 disposed within the housing and adjacent to the explosive charge;
a first electrically conducting post disposed through the housing base and electrically connecting to the first land; and
a second electrically conducting post disposed through the housing base and electrically connecting to the second land.

11. A method for forming an integrated barrel/bridge detonator subassembly, comprising the steps of:
curing a layer ofpolyimide material;
attaching a single layer of conducting material directly to a first surface of the cured polyimide layer;
forming a first land, a second land, and a bridge connecting the first land and the second land from the conducting material;
forming a layer of an insulating material;
punching an opening through the layer of insulating material; and
attaching the layer of insulating material directly to a second surface of the cured polyimide layer,
wherein the opening is disposed opposite from the bridge with a portion of the layer of polyimide material disposed therebetween.

12. The method of claim 11, wherein the single layer of conducting material is flat,
wherein when the single layer of conducting material has been attached to the first surface of the cured polyimide layer, no portion of the single layer of conducting material extends beyond a plane defined by the first surface of the cured polyimide layer.

13. The method of claim 12, further comprising a step of sputtering the layer of conducting material upon the cured polyimide layer.

14. The method of claim 13, further comprising a step of etching the first land, the second land, and the bridge connecting the first land and the second land from the conduction material on the cured polyimide layer.

15. The method of claim 11, further comprising a step of attaching a barrier layer adjacent to and overlaying the single layer of conducting material, wherein the barrier layer further comprises at least one aperture exposing at least a portion of the first land and the second land,
wherein, when the barrier layer is adjacent to and overlaying the single layer of conducting material, no portion of the single layer of conducting material extends beyond a plane defined by a surface of the barrier layer, with which the single layer of conducting material is in contact.
